Europäisches Patentamt

European Patent Office

Office européen des brevets

(11) Veröffentlichungsnummer: **0 305 677**
**A2**

(12) **EUROPÄISCHE PATENTANMELDUNG**

(21) Anmeldenummer: 88110312.1

(22) Anmeldetag: 08.07.82

(51) Int. Cl.4: **H03M 7/04** , //G06F7/56, G06F7/72,H03M7/18

(30) Priorität: 08.07.81 DE 3126987
07.07.82 DE 3225404

(43) Veröffentlichungstag der Anmeldung:
08.03.89 Patentblatt 89/10

(60) Veröffentlichungsnummer der früheren
Anmeldung nach Art. 76 EPÜ: 0 098 325

(84) Benannte Vertragsstaaten:
AT DE FR GB

(71) Anmelder: **Siemens Aktiengesellschaft Berlin und München**
**Wittelsbacherplatz 2**
**D-8000 München 2(DE)**

(72) Erfinder: **Schuöker, Dieter, Prof. Dr.**
**Veitingergasse 30/5**
**A-1130 Wien(AT)**
Erfinder: **Klement, Ekkehard, Dr.**
**Akilindastrasse 31**
**D-8032 Gräfelfing(DE)**

(54) Optisches Rechenwerk, Vorrichtung zur Umwandlung von Residuenzahlen in positionsnotierte Zahlen und Verfahren zum Betrieb der Vorrichtung und des Rechenwerks.

(57) Es wird ein optisches Rechenwerk mit einer Vorrichtung zur Umwandlung von Residuenzahlen in positionsnotierte Zahlen und/oder mit einem optischen Addierer, der Residuenzahlen verarbeitet, beschrieben. Die Vorrichtung und der Addierer können eine Einheit bilden. Die Vorrichtung oder der Addierer besteht aus linearen periodischen Strukturen, die gegeneinander verschiebbar sind. Jede Struktur ist je einem der bei der Residuendarstellung verwendeten Primzahlmoduln zugeordnet und die Periodenlängen dieser Strukturen sind diesen Moduln proportional. Die Strukturen werden vorzugsweise als stehende Lichtwellen realisiert. Die Verschiebung der Phasenlagen erfolgt mittels Phasenmodulatoren. Die Strukturen werden entsprechend den vorgegebenen und zugeordneten Residuenwerten bzw. Summen dieser Werte aus einer ursprünglichen Phasenlage verschoben. Das Ergebnis kann dort entnommen werden, wo Phasen der einzelnen Strukturen, die vor der Verschiebung zusammengefallen sind, nach der Verschiebung wieder zusammenfallen. Die durch diese Stelle positionsnotierte Zahl ist das Ergebnis der Dekodierung oder Addition. Der Aufbau dieser Vorrichtung ist sehr einfach und es lassen sich mit ihr sehr hohe Rechengeschwindigkeiten erreichen.

FIG 3

## Optisches Rechenwerk, Vorrichtung zur Umwandlung von Residuenzahlen in positionsnotierte Zahlen und Verfahren zum Betrieb der Vorrichtung und des Rechenwerks.

Die vorliegende Erfindung bezieht sich auf ein optisches Rechenwerk, auf eine Vorrichtung zum Umwandlung von Residuenzahlen in positionsnotierte Zahlen und Verfahren zum Betrieb der Vorrichtung.

Eine Alternative zu der heute in elektronischen Rechnern verwendeten Binärdarstellung der Daten stellt deren Residuendarstellung dar. Bei dieser tritt kein Übertrag zwischen den Stellen auf und es kann daher wesentlich schneller gerechnet werden. Bei der Residuendarstellung (siehe beispielsweise Appl. Optics 18 (1979) S. 149 - 162) werden eine Anzahl Moduln $M_i$ i = 1, 2, 3, ...N verwendet, die Primzahlen sein müssen. Die Residuendarstellung einer gegebenen Zahl Z erhält man, wenn man diese durch jeden der Primzahlmoduln $M_i$ dividiert. Die bei diesen Divisionen übrigbleibenden Reste $R_i$, die Residuen, stellen dann die Repräsentation der Zahl Z im System der N Primzahlmoduln dar, und diese Repräsentation wird im folgenden Residuenzahl genannt. Die höchste, eindeutig durch eine Residuenzahl darzustellende Zahl $Z_{max}$ ergibt sich als Produkt aller verwendeten Primzahlmoduln:

$$Z_{max} = \prod_{i=1}^{N} M_i$$

Die Residuendarstellung weist, wie schon erwähnt, den großen Vorteil auf, daß zwischen den einzelnen Stellen kein Übertrag vorgenommen werden muß, weil bei Rechenoperationen nur Reste, nicht aber die Absolutwerte der Stellen erhalten werden müssen.

Außerdem können alle Stellen parallel verarbeitet werden, wodurch eine wesentliche Erhöhung der Rechengeschwindigkeit gegenüber der binären Algebra erzielbar ist.

Eine der Residuendarstellung mit ihrer Parallelität gut angepaßte Möglichkeit zur physischen Darstellung der Residuenwerte besteht darin , daß jedem möglichen Wert einer Stelle ein Lichtweg zugeordnet ist. Hierzu werden zwar außerordnetlich viele parallele Übertragungskanäle benötigt, doch wird dieser Nachteil durch die sehr einfache Ansteuerung, die nur Ein- oder Ausschaltvorgänge benötigt, ausgeglichen. Diese besondere Art einer räumlichen Modulation wird auch als "Positionsnotation" (siehe Appl. Optics 18 (1979) S. 149-162) bezeichnet. Eine positionsnotierte Zahl ist eine durch Positionsnotation dargestellte Zahl.

Eine Rechenoperation kann einfach dadurch ausgeführt werden, daß einzelne und mehrere Lichtwege räumlich vertauscht werden, was in einer Ebene erfolgen kann, weil sich Lichtstrahlen durchdringen können. Man kommt so auf eine besonders einfache Bauart der die Rechenoperationen ausführenden Bauelemente. Da in solchen Bauelementen eigentlich nur die Ein- und Ausgänge durchverbunden sind, ermöglichen sie ein besonders schnelles Rechnen. Daraus folgt, daß die Kombination von Residuendarstellung und optischer Positionsnctation zu extrem hohen Rechengeschwindigkeiten führt.

Aus dem genannten Artikel in Appl.Optics 18 (1979) S. 149-162 ist ein Bauelement zur Realisierung linearer Funktionen einer Variblen mit Residuenzahlen bekannt. Bei derartigen linearen Funktionen einer Variablen, also der Addition oder Multiplikation mit einer Konstanten, ist jedem Residuum des Arguments einer Residuum des Funktionswertes eindeutig zugeordnet. Dabei ist der Wertevorrat der Funktion genauso groß wie der Wertevorrat des Arguments. Bei Verwendung einer räumlichen Positionsnotation muß für jede Stelle, d.h. jeden Primzahlmodul ein Rechenbauelement vorhanden sein, das so viele Ein- und Ausgänge aufweist, wie bei der Stelle mögliche Residuenwerte auftreten können. Gemäß dem zitierten Artikel kann nun eine lineare Funktion durch bloße Vertauschung der Ausgänge gegenüber den Eingängen des Bauelementes realisiert werden. Danach kann also eine solche lineare Funktion, also praktisch die Addition oder Multiplikation mit einer Konstanten, durch Bauelemente mit einem festen Schaltplan der Verbindungen zwischen den Eingängen und Ausgängen des Bauelements realisiert werden.

Eine solche Vertauschung der Positionen des eintretenden und des austretenden Lichts kann durch die Verbindung der Ein- und Ausgänge mittels Lichtleiter oder durch entsprechende Umlenkung der eintretenden Lichtstrahlen mittels Spiegeln, Gittern oder auch Prismen erreicht werden. Ein solches Bauelement kann viel schneller als elektronische Rechenelemente arbeiten, weil eine Rechenoperation nur so lange dauert, wie sich das Licht vom Eingang zum Ausgang fortpflanzt.

Zur Realisierung linearer veränderlicher Funktionen also der Addition und Multiplikation mit Variablen anstelle von Konstanten muß der Schaltplan eines soeben beschriebenen Bauelements veränderlich sein. Ein solches Bauelement für die Addition und Multiplikation zweier Zahlen über Residuendarstellung mit Positionnotation kann gemäß dem genannten Artikel dadurch realisiert werden, daß ein flächenhafter Lichtleiter mit rechteckigem Umfang verwendet wird, in dem diagonal verlaufend schmale Regionen eingebaut sind, deren Brechungsindex in irgendeiner Weise so umgeschaltet werden kann, daß dann in diesen Zonen Totalreflexion erfolgt. Wenn diese Zonen entsprechend angeordnet sind, so können je nach dem, welche Zone auf Totalreflexion umgeschaltet wird, verschiedene Vertauschungen der Positionen des Lichts zwischen Eingang und Ausgang realisiert werden. Dabei kann die Umschaltung des Brechungsindex zu kleineren Werten als den des Lichtleiters einerseits elektrisch durch die Anwendung des elektrooptischen Effektes erfolgen, es ist aber auch möglich, diese Zonen durch Lichtstrahlen umzuschalten, beispielsweise in einem Gelliumarsenid-Lichtleiter, in dem dann durch den Einfall des Steuerlichtes der Brechungsindex durch Zerstörung von Excitonen verändert wird. (siehe dazu beispielsweise Appl. Physics Letters 35 (1979) S. 451-453).

Die Aufgabe der vorliegenden Erfindung besteht darin, ein optisches Rechenwerk für Rechenoperationen in Residuendarstellung zu schaffen, das mit herkömmlichen, insbesondere binären Datenverarbeitungssystemen kompatibel ist.

Diese Aufgabe wird durch die im kennzeichnenden Teil des Patentanspruchs 1 angegebenen Merkmale gelöst.

In der Regel wird die optisch arbeitende Recheneinheit ein optisches Rechenwerk für die elementaren Rechenoperationen in Residuendarstellung sein.

Ein beispielhaftes, erfindungsgemäßes Rechenwerk besteht z.B. aus einer Einrichtung, die zwei binäre und durch je einen Lichtweg pro Binärstelle parallel übertragene Zahlen in ihre Residuendarstellung umwandelt, einer optischen Recheneinheit, die zwei in Residuendarstellung vorliegende Zahlen addiert und schließlich aus einer Einrichtung, die die resultierende Residuenzahl wieder in eine binär oder dezimal kodierte Zahl umwandelt.

Die Umwandlung einer Binärzahl in ihre Residuendarstellung ist sehr einfach, wenn man die Addition von Residuenzahlen beherrscht, weil man ja nur die Residuen der Gewichte aller jener Binärstellen addieren muß, die den binären Wert oder die Ziffer "1" aufweisen.
Die beiden restlichen Vorgänge der Addition zweier beliebiger Residuenzahlen innerhalb des Bereichs

$$0 < \prod_{i=1}^{N} M_i$$

und der Umwandlung der Ergebnisse in eine Binär- oder Dezimalzahl stellen die wichtigsten Probleme bei der Verwirklichung eines erfindungsgemäßen

optischen Rechenwerks dar.

Bei einem erfindungsgemäßen Rechenwerk ist es zweckmäßig, wenn die Einrichtung zur Umwandlung einer Residuenzahl in eine binär, dezimal oder entsprechend kodierte Zahl aus einer Vorrichtung zur Umwandlung von Residuenzahlen in positionsnotierte Zahlen besteht (Anspruch 2). Aus Appl. Opt. 18 (1979) S. 163-171 ist eine Vorrichtung zur Umwandlung von der Residuendarstellung in Dezimaldarstellung bekannt geworden, bei der die Umwandlung durch zwei räumliche Fourier-Transformationen mittels Linsen und einem Gitter erfolgt, wobei die umgewandelte Zahl in dezimaler Positionsnotation, also an der Lage eines Lichtstrahles relativ zu einem linearen Maßstab abgelesen werden kann.

Derartige Anordnung mit diskreten optischen Bauelementen, wie Linsen und Gittern eignen sich allerdings nicht für eine planare Integration, wie sie für moderne Rechenbausteine in komplexen Systemen erwünscht ist.

Eine von der soeben beschriebenen bekannten Vorrichtung ausgehende Vorrichtung zur Umwandlung von Residuenzahlen in positionsnotierte Zahlen, die eine planare Integration ermöglicht, ist im Anspruch 4 angegeben.

In den Ansprüchen 6 bis 15 sind bevorzugte und vorteilhafte Ausführungsformen der neuartigen Vorrichtung nach Anspruch 3 angegeben.

Insbesondere die im Anspruch 5 angegeben Vorrichtung und ihre in den Ansprüchen 6 bis 9 angegebenen Ausgestaltungen sind durch planare Integration realisierbar. Insbesondere gilt dies aber für die Ausgestaltung gemäß Anspruch 9.

Die Vorrichtung nach Anspruch 4 läßt sich aber auch mit diskreten Bauelementen realisieren.

Eine derartige Ausführungsform, die im wesentlichen rein mechanisch arbeitet, geht aus dem Anspruch 6 hervor.

Eine andere derartige Ausführungsform geht aus dem Anspruch 12 hervor. Diese Ausführungsform arbeitet rein optisch und erlaubt ähnlich, wie die Ausführungsformen gemäß den Ansprüchen 7 bis 11, extrem hohe Rechengeschwindigkeiten.

Für viele Zwecke reicht es aus, das Interferenzmuster so zu erzeugen, wie es im Anspruch 13 angegeben ist.

Insbesondere für eine scharfe Markierung der positionsnotierten Zahlen ist es aber zweckmäßig, die im Anspruch 14 angegebenen Maßnahmen zu ergreifen.

Dabei wird vorteilhafterweise so vorgegangen, wie es im Anspruch 15 angegeben ist.

Es wurde erkannt, daß eine Vorrichtung, wie sie im Anspruch 4 angegeben ist, auch als optischer Addierer für Residuenzahlen geeignet ist. Auf einen derartigen Addierer ist Anspruch 5 gerichtet.

Bevorzugte und vorteilhafte Ausführungsformen eines derartigen Addierers gehen aus den bereits erwähnten Ansprüchen 6 bis 15 hervor.

Ein derartiger Addierer arbeitet äußerst schnell und ist als optisch arbeitende Recheneinheit für ein optisches Rechenwerk nach Anspruch 1 oder 2 hervorragend geeignet.

Es hat sich sogar herausgestellt, daß ein derartiger Addierer für Residuenzahlen die Residuenzahlen zugleich dekodiert und somit zugleich auch als Vorrichtung zur Umwandlung einer Residuenzahl in eine anders kodierte Zahl verwendet werden kann. Dadurch kann aber ein äußerst schnelles und einfach aufgebautes optisches Rechenwerk geschaffen werden, bei welchem die Vorrichtung zur Umwandlung von Residuenzahlen in positionsnotierte Zahlen zugleich einen optischen Addierer für Residuenzahlen bildet.

Eine Vorrichtung zur Umwandlung von Residuenzahlen in positionsnotierte Zahlen oder ein erfindungsgemäßer Addierer für Residuenzahlen wird so betrieben, daß die periodischen Strukturen entsprechend den vorgegebenen und zugeordneten Residuenwerten bzw. Summen dieser Werte aus einer ursprünglichen Phasenlage verschoben werden und das Ergebnis dort entnommen wird, wo Phasen der einzelnen Strukturen, die vor der Verschiebung zusammengefallen sind, nach der Verschiebung zusammenfallen (Anspruch 16).

Die Erfindung wird anhand der beigefügten Figuren in der nun folgenden Beschreibung näher erläutert. Von den Figuren zeigen:

Figur 1 einen Ausschnitt aus einer Vorrichtung die zur Umwandlung von Residuenzahlen in positionsnotierte Zahlen geeignet ist, die aber praktisch schwer realisierbar ist,

Figur 2 in schematischer Darstellung eine Ausführungsform einer erfindungsgemäßen Vorrichtung zur Umwandlung von Residuenzahlen in positionsnotierte Zahlen,

Figur 3 eine Realisierung einer Vorrichtung nach Figur 2, bei der die periodischen Strukturen durch stehende Lichtwellen in Streifenleitern erzeugt werden,

Figur 4 in schematischer Darstellung eine andere Realisierung einer Vorrichtung nach Figur 2, bei der die periodischen Strukturen durch Interferenzmuster realisiert werden,

Figur 5 eine Ausführungsform eines erfindungsgemäßen Addierers, der im wesentlichen so aufgebaut ist, wie die Vorrichtung nach Figur 3, und

Figur 6 einen Addierer, welcher im wesentlichen so aufgebaut ist, wie die Vorrichtung nach Figur 4.

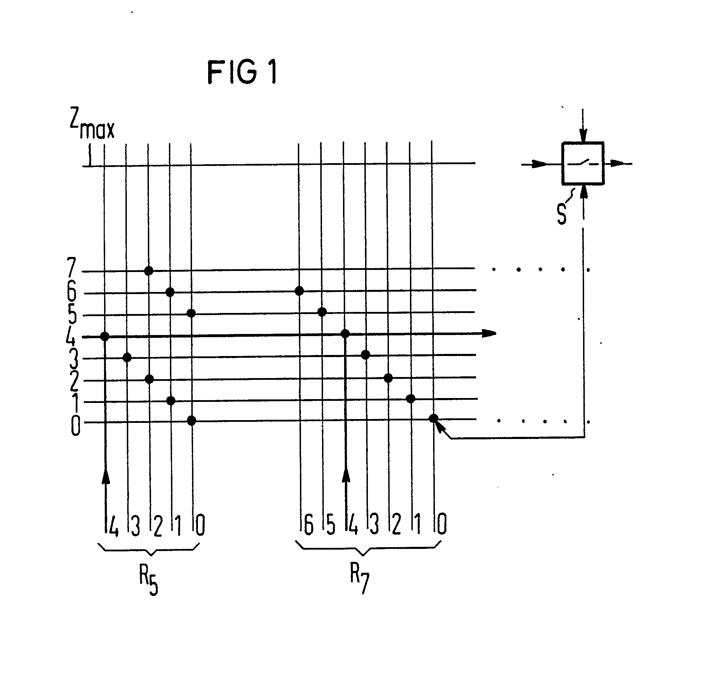

Es wird zunächst näher auf die Umwandlung von Residuenzahlen in positionsnotierte Dezimalzahlen eingegangen. Die Umwandlung von Residuenzahlen $R_1...R_n$ in Dezimalzahlen Z kann bei Positionsnotation grundsätzlich durch eine rechteckige Matrix aus Lichtwegen erfolgen. In der Figur 1 ist eine derartige Matrix schematisch dargestellt, in der sowohl die horizontalen als auch die vertikalen Linien jeweils Lichtwege bedeuten. Die horizontalen Linien repräsentieren die Dezimalzahlen. Gruppen von vertikalen Linien repräsentieren die Residuen. Jede Gruppe vertikaler Linien steht für einen Modul $M_i$ und weist genau $M_i$ vertikale Leitungen auf.

Wenn in denjenigen Schnittpunkten von Leitungen, für die $Z_n = nM_i + R_i$, i = 1, 2, ..., N erfüllt ist, ein Schalter in der horizontalen Leitung durch die vertikale Leitung betätigt wird, so bewirkt die Aktivierung derjenigen vertikalen Leitungen, die den vorliegenden Residuenwerten entsprechen, daß in jeder Gruppe von vertikalen Leitungen alle Schalter geschlossen werden, die in denjenigen horizontalen Leitungen liegen, für die $Z_n = nN_i + R_i$ gilt. Diejenige horizontale Leitung, in der alle Schalter geschlossen sind, entspricht dann der resultierenden Dezimalzahl die alle Gleichungen Z = $n_1M_1 + R_1 = n_2M_2 + R_2 = ... = NM_N + R_N$ erfüllt.

In der Figur 1 ist nur ein Ausschnitt aus einer vollständigen Matrix gezeichnet,und zwar sind nur die horizontalen Leitungen, welche die positionsnotierten Zahlen 0 bis 7 und am oberen Ende noch die maximale positionsnotierte Zahl $Z_{max}$ bezeichnen. Von den Gruppen vertikaler Leitungen sind nur zwei Gruppen dargestellt, welche den beiden Primzahlmoduli $M_5 = 5$ und $M_7 = 7$ zugeordnet sind. Die dem Primzahl modul 5 zugeordnete Gruppe weist fünf vertikale Leitungen auf, welche den fünf möglichen Residuen 0 bis 4 zugeordnet sind. Die zum Primzahlmodul 7 gehörige Gruppe weist sieben vertikale Leitungen auf, welche den sieben möglichen Residuen 0 bis 6 zugeordnet sind. Ein mit einem schwarzen Punkt gekennzeichneter Schnittpunkt bedeutet, daß an dieser Stelle ein Schaltelemente vorgesehen ist, welches über die vertikale Leitung auf und zu gesteuert werden kann und welches die horizontale Leitung unterbricht oder schließt. Ein derartiges Schaltelement ist in der Figur 1 schematisch dargestellt und mit S bezeichnet.

Wenn beispielsweise die in der elektronischen Datenverarbeitung üblichen Binärzahlen mit sechzehn Stellen in Residuendarstellung verarbeitet werden sollen, muß die soeben beschriebene Matrix rund 64.000 horizontale Leitungen, aber nur etwa 100 vertikale Leitungen umfassen. Die Lösung des Problems, derartig viele Lichtleiter in ein optisches Bauelement zu packen, scheint mit der derzeit verfügbaren Technologie der integrierten Optik noch nicht möglich zu sein. Die erforderlichen Schaltelemente sind in so großer Zahl nicht zu verpacken, insbesondere schon deshalb nicht, weil rein optische Schalter nicht existieren, sondern nach wie vor optoelektronisch gearbeitet werden muß. Davon abgesehen ist auch das Zusammenpaken einer so großen Zahl von Leitungen auf engem Raum keineswegs unproblematisch.

Diese Probleme lassen sich mit der hier vorgeschlagenen Vorrichtung beseitigen.

Dieser Vorschlag benutzt die Erkenntnis, daß die positionsnotierten Zahlen, beispielsweise Dezimalzahlen wie bei der Figur 1, anstatt durch parallele Leitungen durch eine Anzahl von periodischen linearen Strukturen mit Periodenlängen, die jeweils einem Primzahlmodul $M_i$ proportional sind, beispielsweise durch lineare Strukturen mit periodischen Marken, deren Abstände jeweils einem Primzahlmodul $M_i$ proportional sind, repräsentiert werden können.

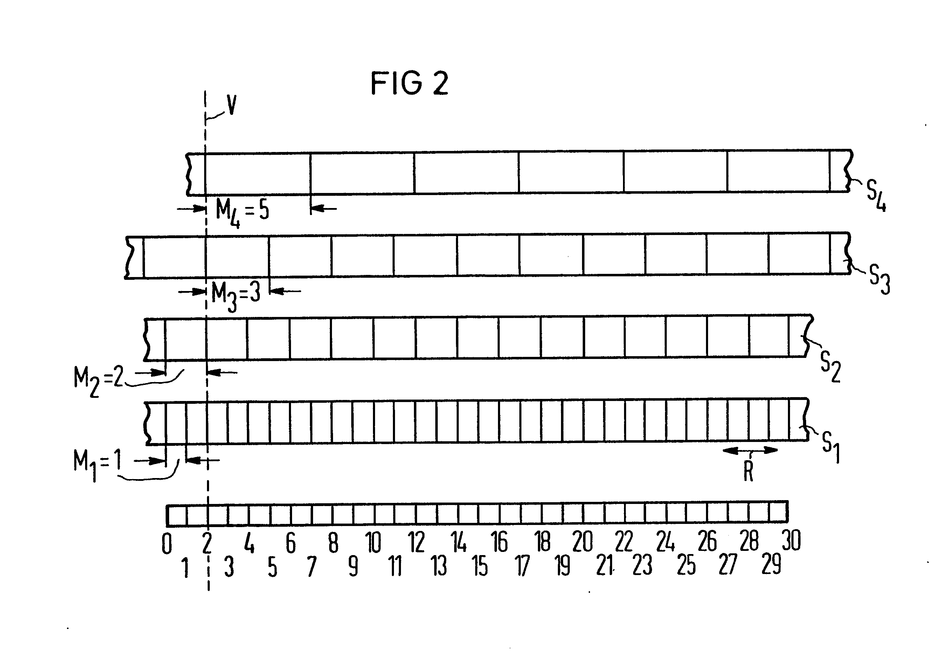

Die Figur 2 zeigt in schematischer Darstellung eine Ausführungsform einer derartigen Vorrichtung. Bei dieser Vorrichtung ist vorausgesetzt, daß die Residuendarstellung mit den Primzahlmoduln 1, 2, 3 und 5 erfolgt. Die maximale eindeutig darstellbare Zahl ist dann gegeben durch $Z_{max} = 30$.

Die Zahlen 0 bis 30 sind in der Figur 2 unten auf einem linearen Maßstab positionsnotiert. Über dem linearen Maßstab sind parallel dazu vier periodische lineare Strukturen $S_1$, $S_2$, $S_3$ und $S_4$ angeordnet, die relativ zueinander und längs des linearen Maßstabes, also in Richtung des Doppelpfeiles R, verschiebbar sind.
Die Strukturen $S_1$ bis $S_4$ weisen jeweils äquidistante Marken auf. Der Markenabstand der Struktur $S_1$ entspricht dem Primzahlmodul $M_1$ und damit der durch den Maßstab gegebenen Einheit. Der Markenabstand der Struktur $S_2$ entspricht dem Primzahlmodul $M_2$ und damit der doppelten Einheit. Der Markenabstand der Struktur $S_3$ entspricht dem Primzahlmodul $M_3$ und damit der dreifachen Einheit. Schließlich entspricht der Markenabstand der Struktur $S_4$ dem Primzahlmodul $M_4$ und damit der fünffachen Einheit.

Um mit der soeben beschriebenen Vorrichtung eine gegebene Residuenzahl in eine positionsnotierte Zahl umzuwandeln, wird so vorgegangen, daß die vier Strukturen $S_1$ bis $S_4$ in eine Lage gebracht werden, daß Marken sämtlicher Strukturen über der positionsnotierten Null übereinander, d.h. auf einer vertikalen Linie durch die positionsnotierte 0 liegen. Von dieser Nullstellung aus wird jede Struktur soweit nach rechts verschoben, wie das ihrem Primzahlmodul zugeordnete Residuum angibt. Die Stelle, bei der Marken sämtlicher Strukturen, also insgesamt vier Marken übereinander und damit auf einer vertikalen Linie liegen, zeigt die zu der betreffenden Residuenzahl gehörige positionsnotierte Zahl an. In der Figur 2 wird die positionsnotierte 2 angezeigt, weil genau vier Marken auf einer durch die positionsnotierte 2 gehenden vertikalen Linie V liegen, die gestrichelt angedeutet ist.

Bei den vorausgesetzten Primzahlmoduln $M_1 = 1$, $M_2 = 2$, $M_3 = 3$ und $M_4 = 5$ gilt: $2 = 2 \cdot M_1 + 0 = 1 \cdot M_2 + 0 = 0 \cdot M_3 + 2 = 0 \cdot M_5 + 2$ d.h., daß bei dieser Residuendarstellung 2 durch die Residuenzahl (0, 0, 2, 2) repräsentiert ist. Dies bedeutet, daß die Strukturen $S_1$ und $S_2$ aus ihrer Nullstellung nicht zu verschieben sind, während die Strukturen $S_3$ und $S_4$ um zwei Einheiten nach rechts zu verschieben sind. Führt man dies aus, so gibt sich die in Figur 2 dargestellte Konfiguration.

Eine praktische Realisierung der in Figur 2 dargestellten Vorrichtung ist beispielsweise die Überlagerung linearer Lochmasken, bei denen jede Marke durch ein Loch oder Fenster repräsentiert ist. Eine Stelle, wo sämtliche Marken oder Löcher nach den durch die vorgegebene Residuenzahl vorgenommenen Verschiebungen zusammenfallen, wird die Vorrichtung durchsichtig und kennzeichnet auf diese Weise die zugeordnete positionsnotierte Zahl.

Da eine derartige Vorrichtung im wesentlichen mechanisch arbeitet, kommt sie für schnell arbeitende Rechenwerke nicht in Frage.

Die linearen periodischen Strukturen können aber auch mit optischen Mitteln, beispielsweise durch stehende Wellen realisiert werden. Die äquidistanten Marken sind dabei durch eine bestimmte Phase dieser stehenden Wellen realisiert, beispielsweise durch deren Knoten. Die Verschiebung der stehenden Wellen kann durch Phasenmodulatoren erfolgen, die vor den zur Erzeugung der stehenden Wellen erforderlichen Reflektoren angeordnet sind und die die Welle vor- und zurückschieben. Wenn durch Licht induzierte dispersive Effekte, wie etwa die Verringerung des Brechungsindex von III - V Halbleitern durch Zerstörung der Excitonen verwendet werden, dann kann der Modulator durch einen Lichtstrahl angesteuert werden und damit eine rein optische Anordnung realisiert werden.

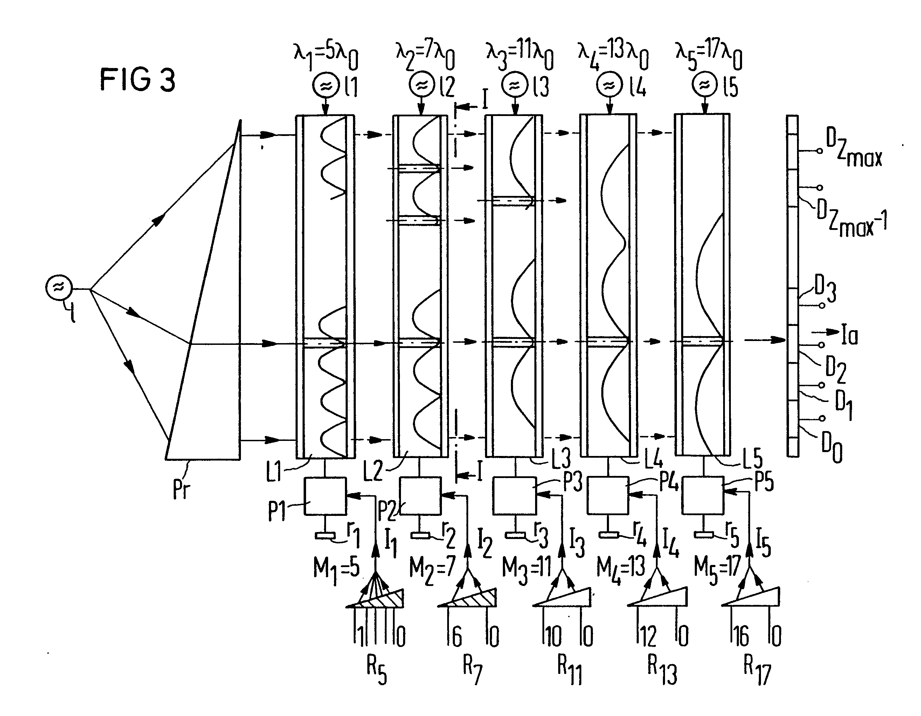

Die Figur 3 zeigt eine derartige Realsierung. Die stehenden Wellen werden bei dieser Realisierung in parallelen Streifenleitern L1 bis L5 erzeugt, die aus einem Material bestehen, das eine lichtinduzierte Beeinflussung des Brechungsindex erlaubt und deren Längsseiten teildurchlässig verspiegelt sind, damit sie in transversaler Richtung einen Fabry-Perot -Resonator bilden, der für kritische Werte des Brechungsindex in transversaler Richtung durchsichtig wird. Bei geeigneter Dimensionierung der Breite des Streifenleiters kann erreicht werden, daß die Struktur gerade dort, wo die Knoten der stehenden Welle liegen, transversal einfallendes Licht gut transmittiert und überall anders nur wenig durchläßt.

Zur Erzeugung der stehenden Wellen sind Lichtquellen I1 bis I5 vorgesehen, die Licht verschiedener Wellenlängen aussenden. Jede dieser Lichtquellen $I_i = 1,2,...,5$ sendet eine Lichtwellen-

länge $\lambda_i$ = $M_i \cdot \lambda_0$ aus. $M_i$ ist der der Lichtquelle $l_i$ bzw. dem Streifenleiter Li zugeordnete Primzahlmodul. Dadurch entspricht der Knotenabstand der im Streifenleiter Li erzeugten stehenden Welle dem zugeordneten Primzahlmodul $M_i$. Bei der in Figur 3 dargestellten Vorrichtung gilt speziell $M_1 = 5$, $M_2 = 7$, $M_3 = 11$, $M_4 = 13$ und $M_5 = 17$. Die diesen Primzahlmoduln zugeordneten Residuen $R_5$, $R_7$, $R_{11}$, $R_{13}$ und $R_{17}$ können die Zahlen 0 bis 4, 0 bis 6, 0 bis 10, 0 bis 12, bzw. 0 bis 16 annehmen.

Die zur Erzeugung der stehenden Wellen erforderlichen Reflektoren sind in der Figur 3 mit $r_1$ bis $r_5$ bezeichnet. Zwischen jedem Streifenleiter Li und dem ihm zugeordneten Reflektor $r_i$ ist ein Phasenmodulator Pi, i = 1 bis 5 angeordnet, der durch einen Lichtstrahl $l_i$ gesteuert wird. Die durch einen derartigen Phasenmodulator erzeugte Phasenverschiebung ist um so größer, je größer die Intensität des steuernden Lichtstrahles ist.

Die Intensität eines steuernden Lichtstrahles muß stufenweise verändert werden können, und zwar ent sprechend den möglichen Residuenwerten.So muß beispielsweise der Lichtstrahl $l_1$ in fünf Intensitätsstufen verändert werden können, die den Residuenwerten 0, 1, ...4 des Residuums $R_5$ entsprechen. Analoges gilt für die anderen steuernden Lichtstrahlen $l_2$ bis $l_5$. Die stufenweise Veränderung der Intensität kann durch Überlagerung einzelner Lichtstrahlen erfolgen, wie es in der Figur 3 angedeutet ist.

Die Streifenleiter Li werden mit einer von einer Lichtquelle 1 und einem Prisma Pr erzeugten ebenen Lichtwelle transversal bestrahlt. Die Streifenleiter sind für dieses Licht in den Knoten der in ihnen erzeugten stehenden Wellen lichtdurchlässig. Die ganze Wellenleiterstruktur ist aber für dieses Licht nur dort durchlässig, wo Knoten sämtlicher Wellenleiter in Ausbreitungsrichtung der ebenen Wellen hintereinander angeordnet sind. Dies ist immer nur an einer bestimmten Stelle der Fall und diese Stelle, an der Licht aus der gesamten Wellenleiterstruktur austritt, gibt die positionsnotierte Zahl an.

Dazu kann beispielsweise ein Detektorfeld verwendet werden, welches $Z_{max}$ + 1 lichtempfindliche Einzeldetektoren $D_0$ bis $D_{z\,max}$ aufweist. Bei dieser Bezeichnung der Einzeldetektoren kann die positionsnotierte Zahl gleich dem Index gesetzt werden. Die Vorrichtung nach Figur 3 zeigt beispielsweise die positionsnotierte Zahl 2 an, weil der Detektor $D_2$ angeregt wird.

Die in Figur 3 dargestellte Vorrichtung eignet sich gut für die Realisierung mit den Mitteln der integrierten Optik und hat den beträchtlichen Vorteil, daß die Umwandlung durch die parallele Arbeitsweise sehr rasch erfolgt.

Die periodischen Strukturen können auch durch Interferenz, beispielsweise durch Zweistrahlinterferenz, erzeugt werden, bei der die Überlagerung zweier ebener Lichtwellen, deren Ausbreitungsrichtungen einen Winkel einschließen, in einer auf beide Ausbreitungsrichtungen senkrechten Ebene eine Amplitudenverteilung entsprechend einer stehenden Welle ergibt. Der Abstand $\Gamma$ der Interferenzstreifen ist durch die Wellenlänge $\lambda$ und den Winkel $\alpha$ zwischen den beiden Ausbreitungsrichtungen gegeben durch

$$\Gamma = \frac{\lambda}{2} \frac{1}{\sin(\alpha/2)\cos\beta}$$

und wird bei kleinen Winkeln $\alpha$ sehr groß. $\beta$ ist der Winkel zwischen der Beobachtungsebene und der Normalen auf die Winkelhalbierende von $\alpha$.

Die zur Darstellung der einzelnen Residuenwerte nötige Verschiebung der Interferenzstreifen kann durch einen Phasenmodulator erzeugt werden, der die Phasenlage eines der beiden Strahlen verschiebt.

Da für jeden der bei der Residuendarstellung verwendeten Primzahlmoduln ein derartiges Interferenzmuster erzeugt werden muß, dessen Streifenabstand den zugeordneten Modul proportional ist, muß mit entsprechend vielen verschieden gerichteten Lichtstrahlen gearbeitet werden.

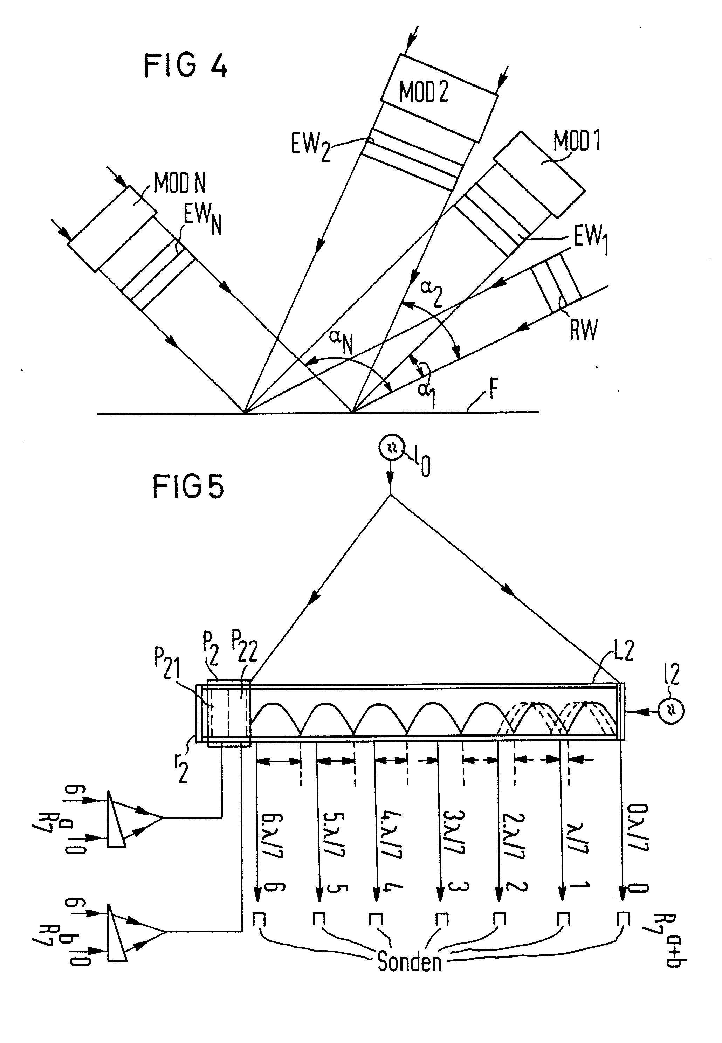

Die Figur 4 zeigt in schematischer Darstellung eine derartige Vorrichtung für Residuenzahlen, die auf N Moduln $M_1$, $M_2$, ...$M_N$ basieren. Zur Erzeugung der dafür notwendigen N Interferenzmuster werden N ebene Wellen $EW_1$, $EW_2$, ...,$EW_N$ verwendet, die unter N verschiedenen Winkeln $\alpha_1$, $\alpha_2$, ..., $\alpha_N$ mit einer Referenzwelle RW zur Interferenz gebracht werden. Dabei bildet sich in einer Ebene, die auf einer alle Ausbreitungsrichtungen enthaltenden und in der Figur 4 mit der Zeichenebene zusammenfallenden Ebene senkrecht steht, ein resultierendes Interferenzmuster aus, das der kohärenten Überlagerung von N + 1 Wellen entspricht. In der Ebene, in der das resultierende Interferenzmuster entsteht, ist ein Schirm F angeordnet. Jede der ebenen Wellen $EW_1$, $EW_2$,...,$EW_N$ durchläuft je einen Phasenmodulator MOD1, MOD2, ...,MODN mit dem die Phasenlage der betreffenden Welle verschiebbar ist.

Werden die Phasenlagen der N einfallenden Wellen entsprechend den N gegebenen Residuenwerten verschoben, so werden auch die Streifen der N Interferenzmuster auf dem Schirm F verschoben und es kann auf einem darauf gedachten linearen Maßstab, die den Residuenwerten entsprechende positionsnotierte Zahl an der einzigen Stelle abgelesen werden, wo alle N Interferenzmuster ein gemeinsames Maximum aufweisen.

Die Auswertung kann beispielsweise und ähnlich wie bei der Vorrichtung gemäß Figur 3 mittels eines optoelektronischen Detektorfeldes erfolgen. Der Detektor, bei dem das Maximum liegt, gibt ein charakteristisches Signal ab, welches beispielsweise auf die zugeordnete positionsnotierte Zahl in irgendeiner kodierten Form zeigt.

Die Vorrichtung gemäß Figur 4 kann auch mit den Mitteln der integrierten Optik, beispielsweise durch N streifenförmige Lichtwellenleiter realisiert werden, die unter N spitzen Winkeln $\alpha_1$, $\alpha_2$, ..., $\alpha_N$ zu einem Referenzwellenleiter verlaufen und in denen je ein Modulator angeordnet ist.

Die Modulatoren MOD1, MOD2, ...,MODN müssen wie bei der Vorrichtung gemäß Figur 3 steuerbar sein, weil ja die räumliche Verschiebung jedes Interferenzmusters dem jeweils zugeordneten, aber veränderlichen Residuenwert proportional sein muß. Die Residuenwerte liegen meist in Positionsnotation vor und es kann daher jeder der genannten Modulatoren aus N hintereinander geschalteten Einzelmodulatoren bestehen, von denen jeder je eine der den möglichen Residuenwerten entsprechenden Phasenverschiebungen erzeugt.

Da bei optischen Recheneinheiten Zahlen und daher auch die einzelnen Residuenwerte in positionsnotierter Darstellung durch Lichtwege charakterisiert werden, ist es zweckmäßig, wenn sämtliche Einzelmodulatoren optisch steuerbar sind. Jeder der Lichtwege führt dann zu genau einem dieser Einzelmodulatoren und jeder Einzelmodulator ist so eingestellt, daß er genau die Phasenverschiebung erzeugt, die der positionsnotierten Zahl entspricht, die durch den Lichtweg bestimmt ist, der ihm zugeführt ist.

Diese spezielle optische Steuerung ist aber, obwohl sehr vorteilhaft, nicht notwendig erforderlich. Die Positionsnotation der möglichen Residuenwerte ist allein schon durch die räumliche Anordnung der Einzelmodulatoren und der den Residuenwerten zugeordneten Phasenverschiebungen gegeben, die sie bewirken.

Bei vorgegebenem Residuenwert ist lediglich der zugeordnete Einzelmodulator in geeigneter Weise anzusteuern.

Wenn die Zweistrahlinterferenz nicht zu einem ausreichend scharfen oder zu einem sich nicht deutlich genug gegenüber die Umgebung abhebenden gemeinsamen Maximum oder Minimum führt, wird zweckmäßigerweise anstelle der Zweistrahlinterferenz eine Vielstrahlinterferenz angewendet. Dazu eignet sich beispielsweise ein Fabry-Perot-Interferometer. Bei einem solchen Interferometer ist der Streifenabstand nicht wie bei der Zweistrahlinterferenz konstant, wenn ein ebener Schirm verwendet wird, sondern der Abstand nimmt bei den beispielsweise als konzentrische Ringe vorliegenden Streifen radial nach außen hin zu. Durch Verwendung eines geeignet gewölbten Schirmes kann der Streifenabstand aber wieder konstant gemacht werden.

Aus jeder der in Figur 3 oder 4 dargestellten Vorrichtungen läßt sich ein Addierer für Residuenzahlen konstruieren. Dazu muß statt einem Modulator je periodischer Struktur eine der Anzahl der zu addierenden Residuenzahlen entsprechende Zahl von Modulatoren vorhanden sein, die durch Signale anzusteuern sind, die den zu addierenden Residuen entsprechen. Außerdem ist neben jeder der periodischen Strukturen ein linearer Maßstab anzuordnen, der gedacht sein kann, und auf dem Zahlen positionsnotiert sind, die den möglichen Residuenwerten entsprechen.

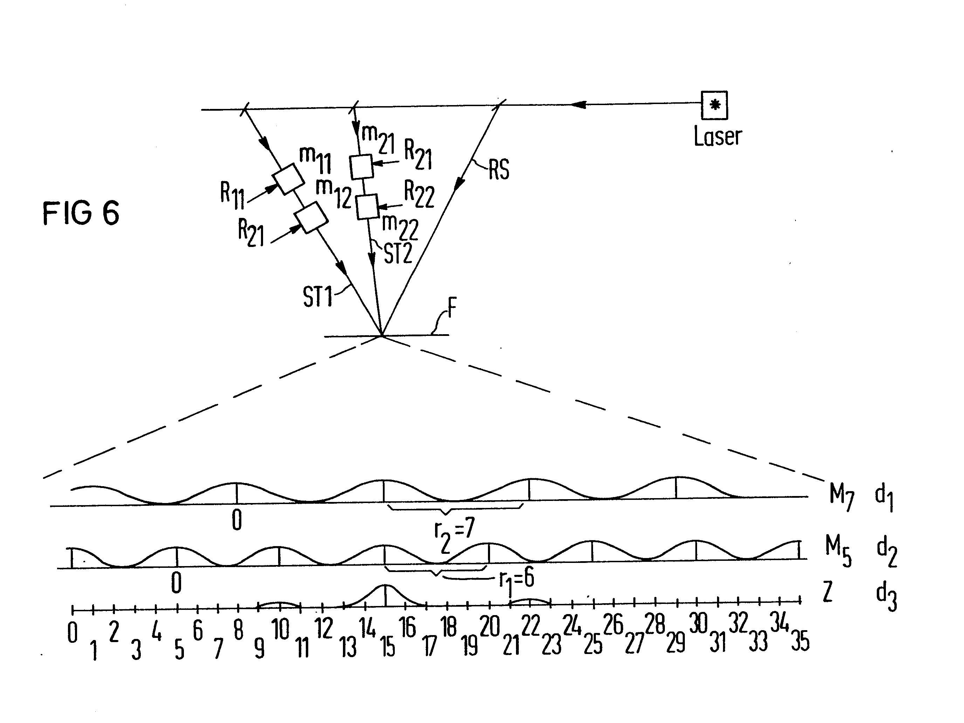

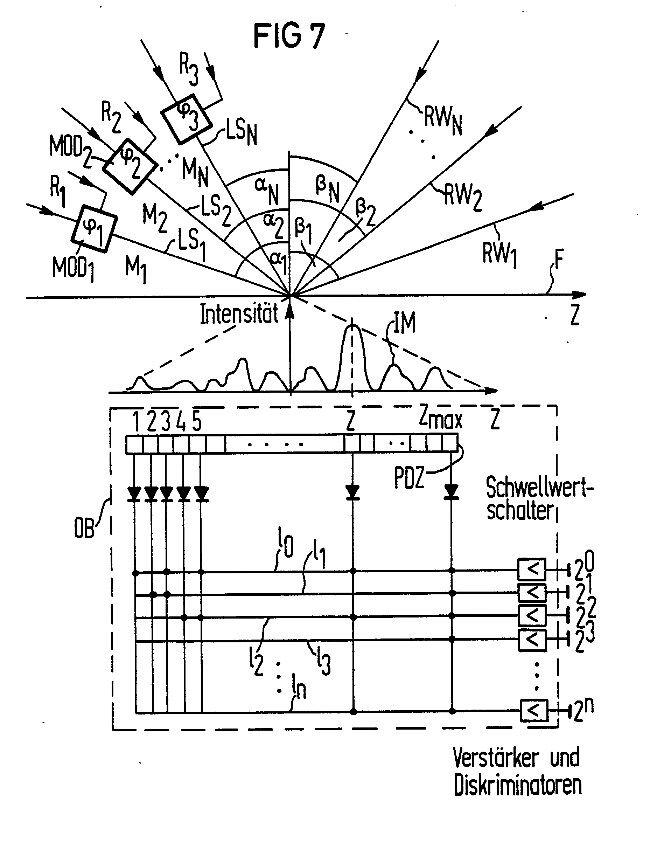

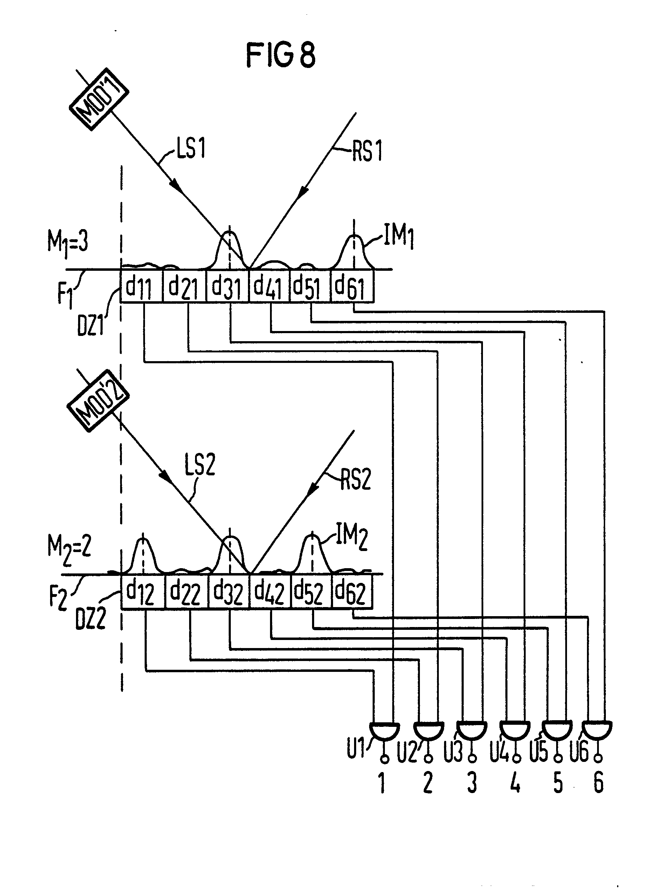

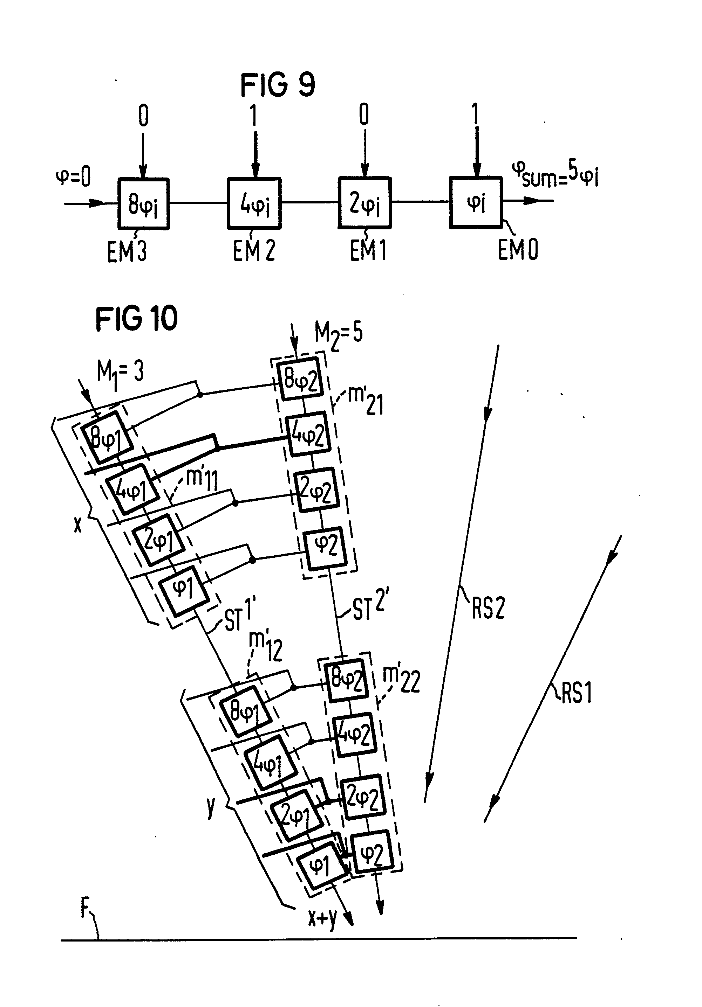

Eine erste Ausführungsform eines derartigen Addierers zeigt die Figur 5, die im wesentlichen der in Figur 3 dargestellten Struktur entspricht. Die Figur 5 stellt einen Querschnitt durch die in Figur 3 dargestellte Vorrichtung längs der Schnittlinie I - I dar. Unter dem Streifenleiter L2 sind Sonden angeordnet, welche die möglichen Residuenwerte 0 bis 6 des Residuums $R_7$ zum Primzahlmodul 7 positionsnotieren. Der Abstand der Sonden voneinander ist dem siebten Teil der Wellenlänge der stehenden Welle im Wellenleiter proportional. Generell ist der Abstand zwischen benachbarten Sonden proportional zum Quotienten aus Periodenlänge einer Struktur und dem dieser Struktur zugeordnete Modul zu wählen. Unter jeder vorhandenen Struktur, und damit unter jedem der Streifenleiter L1 bis L5 sind derartig Sonden anzuordnen.

Ein wesentlicher Unterschied der in Figur 5 dargestellten Vorrichtung zu der in Figur 3 dargestellten besteht darin, daß jeder Modulator zwei Einzelmodulatoren aufweist, die getrennt durch zwei zu addierende Residuenwerte anzusteuern sind. In der Figur 5 steuert ein erster Residuenwert $R_7^a$ einen ersten Einzelmodulator P21 und ein zweiter Residuenwert $R_7^b$ den zweiten Einzelmodulator P22.

Beim Betrieb des Addierers wird dieser von oben mit einer Lichtquelle beleuchtet und in sämtlichen Streifenleitern werden stehende Wellen erzeugt. Die durch die beiden Modulatoren erzeugten Verschiebungen der stehenden Wellen entsprechen einer Gesamtverschiebung, die dem Summenwert $R_7^{a+b}$ der zu addierenden Residuen entspricht. Dieser Wert wird dadurch angezeigt, daß ein Knoten der stehenden Welle und damit eine durchsichtige Stelle des Streifenleiters genau über einer bestimmten Sonde liegt und dadurch Licht aus der Lichtquelle $L_0$ auf diese Sonde trifft. Die durch diese Sonde positionsnotierte Zahl entspricht dem Summenwert.  .

An sich genügt für diese Anordnung eine einzige Halbwelle. Zur Erhöhung der Genauigkeit kann aber auch für jeden Wert des Residuums die zugeordnete Sonde in einer anderen Halbwelle liegen, so wie es in der Figur 5 dargestellt ist. Der Addierer arbeitet vollkommen parallel und ist daher sehr schnell.

In der Figur 6 ist ein optischer Addierer dargestellt, welcher einer Vorrichtung nach Figur 4 entspricht, und der demnach mit Interferenz arbeitet.

Bei diesem Addierer werden ein Referenzstrahl RS, ein erster Strahl ST1 und ein zweiter Strahl ST2 die mit Hilfe von teildurchlässigen Spiegeln aus einem Laserstrahl abgezweigt werden, auf einem Schirm F zur Interferenz gebracht. In dem ersten Strahl ST1 sind zwei Phasenmodulatoren $m_{11}$, $m_{12}$ hintereinander angeordnet und dem zweiten Strahl ST2 zwei Phasenmodulatoren $m_{21}$ und $m_{22}$.

Dabei ist angenommen, daß zur Residuendarstellung zwei Moduln $M_5 = 5$ und $M_7 = 7$ verwendet sind. Damit ist $Z_{max} = 35$.

Es sollen zwei Residuenzahlen $(R_{11}, R_{12}) = (1, 6)$ und $(R_{21}, R_{22}) = (4, 2)$ addiert werden. Diese beiden Residuenzahlen sind die Residuendarstellung der beiden Dezimalzahlen 6 bzw. 9.

Unter dem Schirm F sind in der Figur 6 schematisch Interferenzmuster über einem Maßstab dargestellt, auf dem die Zahlen 0 bis 35 äquidistant aufgetragen sind. Wegen der besseren Übersichtlichkeit sind die auftretenden Nebenmaxima weggelassen worden. Das Diagramm $d_1$ entspricht einem Interferenzmuster welches von dem Strahl ST2 und dem Referenzstrahl RS auf dem Schirm F erzeugt wird. Der Streifenabstand $\Gamma_2$ dieses dem Modul $M_7$ zugeordneten Interferenzmusters beträgt sieben Maßstabseinheiten. Die beiden Modulatoren $m_{21}$ und $m_{22}$ bewirken eine Phasenverschiebung, die $R_{12} + R_{22}$ entspricht. Bei dem angegebenen Zahlenbeispiel entspricht dies acht Maßstabseinheiten. Das bedeutet, daß die Phasenlage des Interferenzmusters $d_1$ um acht Einheiten nach rechts verschoben ist. Die ursprünglich bei null liegende Phase ist durch eine 0 gekennzeichnet.

Das durch den Strahl ST1 und den Referenzstrahl erzeugte Interferenzmuster, das dem Modul $M_5$ zugeordnet ist, ist im Diagramm $d_2$ dargestellt. Bei diesem Muster entspricht der Streifenabstand $\Gamma_1$ fünf Maßstabseinheiten. Die Modulatoren $m_{11}$ und $m_{12}$ verschieben die Phasenlage des Interferenzmusters $d_2$ um $R_{11} + R_{21}$ nach rechts. Dies entspricht $1 + 4 = 5$ Maßstabseinheiten. Auch in diesem Interferenzmuster ist die ursprünglich bei 0 liegende Phase durch eine 0 gekennzeichnet.

In den beiden Diagrammen $d_1$ und $d_2$ sind die Intensitätsmaxima durch die äquidistanten vertikalen Striche gekennzeichnet. Man entnimmt den beiden Diagrammen, daß bei der Zahl 15 die Maxima beider Interferenzmuster zusammenfallen. Das bedeutet, daß das tatsächliche Interferenzmuster, das durch alle drei Strahlen auf dem Schirm F erzeugt wird, dort ein deutliches Intensitätsmaximum aufweisen muß. Im Diagramm $d_3$ ist dieses Maximum

ebenfalls durch einen vertikalen Strich gekennzeichnet. Da die beiden Residuenzahlen den Dezimalzahlen 6 und 9 entsprechen, muß die Summe der Residuenzahlen der Dezimalzahl $9 + 6 = 15$ entsprechen, was tatsächlich der Fall ist.

Der in Figur 6 dargestellte Addierer ist somit zugleich ein optisches Rechenwerk, welches Residuenzahlen verarbeitet und die Ergebnisse in anders kodierter Form liefert. Somit bilden bei einem derartigen Rechenwerk die Recheneinheit, welche die Residuenzahlen verarbeitet und die Vorrichtung zur Umwandlung der Residuenzahlen in anders kodierte Zahlen eine Einheit.

Es sei darauf hingewiesen, daß der in Figur 6 dargestellte Addierer nur ein konkretes Beispiel darstellt, daß ein solcher Addierer aber auch durch die in Figur 3 und generell eine in Figur 2 dargestellte Vorrichtung oder einen entsprechenden Addierer realisiert werden kann.

Ein wesentlicher Vorteil eines derartigen Rechenwerks ist seine erhebliche Schnelligkeit.

## Ansprüche

Vorrichtung zur Umwandlung einer Dualzahl in eine dem Wert dieser Zahl zugeordneten Phasenverschiebung auf einem Lichtstrahl, **dadurch gekennzeichnet,** daß jeder Stelle der Dualzahl ein Phasenmodulator zugeordnet ist, daß diese Phasen-modulatoren hintereinander in dem Lichtstrahl ange-ordnet sind und daß jeder Phasenmodulator eine Phasenverschiebung nur dann erzeugt, wenn der Wert der ihm zugeordneten Dualstelle 1 ist, und daß der der j-ten Stelle der Dualzahl zugeordnete Phasenmodulator eine Phasenverschiebung erzeugt, die gleich dem $2^j$-fachen einer vorbestimmten Phasenverschiebung ist, wobei $j = 0$, 1, ...., n ist und $j = 0$ die niedrigste und $j = n$ die höchste Stelle der Dualzahl bezeichnet.

## FIG 1

# FIG 2

$M_4 = 5$

$S_4$

$M_3 = 3$

$S_3$

$M_2 = 2$

$S_2$

$M_1 = 1$

$S_1$

R

V

0 1 2 3 4 5 6 7 8 9 10 11 12 13 14 15 16 17 18 19 20 21 22 23 24 25 26 27 28 29 30

EP 0 305 677 A2

FIG 3

EP 0 305 677 A2

FIG 4

FIG 5

FIG 6

Laser

EP 0 305 677 A2

# FIG 7

# FIG 8

# FIG 9

# FIG 10